# EUROPEAN PATENT APPLICATION

(11) **EP 2 728 553 A2**
(43) Date of publication of application: **07.05.2014**
(21) Application number: 13189965.0
(22) Date of filing: 23.10.2013
(51) Int. Cl.: G06T 17/20, G06T 19/20

(54) **Method for producing finite element model**

(30) Priority: 05.11.2012 JP 2012243792
(71) Applicant: SUMITOMO RUBBER INDUSTRIES LIMITED, Kobe-shi, Hyogo-ken (JP)
(72) Inventor: Imamura, Ao, Kobe-shi, Hyogo-ken, 651-0072 (JP); Tanimoto, Ryosuke, Kobe-shi, Hyogo-ken, 651-0072 (JP)
(74) Representative: Manitz, Finsterwald & Partner GbR

(57) **Abstract**

A method for producing a finite element model is disclosed.

From a contour data set about the original contour shape of an analysis object, a nonuniformly-scaled contour data set about a nonuniformly-scaled contour obtained by anisotropically scaling up or down the contour shape is reconstructed using a scaling factor. The nonuniformly-scaled contour is divided into a finite number of elements and node points are defined to form a primary model. The primary model is anisotropically scaled by the reciprocal of the scaling factor to form the finite element model having the original contour shape.

## Description

### Background of the Invention

The present invention relates to a method for producing a finite element model, capable of reducing the time to produce the model.

Recently, computer simulations using a finite element model of an analysis object are widely employed for example in order to analyze deformations of the analysis object.

Usually, in order to produce a finite element model, a computer loads contour data including coordinates which specifies the contour of the analysis object. Then, the space defined by the contour data is divided into a finite number of elements, and node points are defined on the elements. Thereby, the finite element model is produced.

Hitherto, when dividing into the elements, a computer divides evenly in every directions (for example, in the cartesian coordinate system, all of the X-axis direction, Y-axis direction and Z-axis direction). As a result, the density of the node points becomes constant in every directions.

when the analysis object has a direction in which the stress gradient of the analysis object is relatively low, if the density of the node points in such direction is decreased, the analytical accuracy as a whole is not affected.

Therefore, in order to increase the computational efficiency, it is preferred that the density of the node points in such direction is decreased. In other words, it is preferred that the density of the node points in a direction in which the stress gradient of the analysis object is relatively high is increased in order to increase the analytical accuracy.

### Summary of the Invention

It is therefore, an object of the present invention to provide a method for producing a finite element model, by which a finite element model in which the density of node points in a certain direction is relatively decreased or increased, can be produced in a short time.

According to the present invention, a method for producing a finite element model of an analysis object, comprises:
a process in which a computer loads a contour data set which is a data set including coordinates which specify the contour of the analysis object,
a nonuniformly-scaling process in which the computer selectively changes the coordinates in the contour data set by using a predetermined scaling factor so as to obtain a nonuniformly-scaled contour data set which specify a nonuniformly-scaled contour obtained by anisotropically scaling up or scaling down the contour of the analysis object according to the scaling factor,
a primary model producing process in which the computer divides the three-dimensional space defined by the nonuniformly-scaled contour data set into a finite number of elements and defines node points on the divided elements so as to form a primary finite element model having the nonuniformly-scaled contour,
a restoring process in which the computer selectively changes the coordinates in the nonuniformly-scaled contour data set and the coordinates of the node points of the primary finite element model by using the reciprocal of the scaling factor so as to obtain the finite element model having the contour of the analysis object obtained by anisotropically scaling down or scaling up the primary finite element model according to the reciprocal of the scaling factor.

As to the coordinate system, the Cartesian coordinate system, a cylindrical coordinate system, a spherical coordinate system or a toroidal coordinate system can be employed according to the analysis object.

### Brief Description of the Drawings

Fig. 1 is a perspective view of a computer implementing a method for producing a finite element model according to the present invention.
Fig. 2 is a schematic perspective view of a pneumatic tire as an analysis object.
Fig. 3 is a cross sectional view of the pneumatic tire.
Fig. 4 is a flow chart of the method for producing a finite element model.
Fig. 5 is a perspective image rendered from the contour data of the tire.
Fig. 6 and Fig. 7 are perspective views showing a primary finite element model and the finite element model of the tire, respectively.
Fig. 8 and Fig. 9 are perspective views showing a primary finite element model and the finite element model of the tire, respectively, which are produced by another embodiment of the present invention.
Fig. 10 is a cross sectional view of a kneading space of a kneading machine as an analysis object.
Fig. 11 is a perspective image rendered from the contour data of the kneading space.
Fig. 12 and Fig. 13 are perspective views showing a primary finite element model and the finite element model of the kneading space, respectively, which are produced by a further embodiment of the present invention.
Fig. 14(a) is a diagram for explaining a cylindrical coordinate system.
Fig. 14(b) is a diagram for explaining a spherical coordinate system.
Fig. 15 is a diagram for explaining a toroidal coordinate system.

### Description of the Preferred Embodiments

Embodiments of the present invention will now be described in detail in conjunction with accompanying drawings.

In the method for producing a finite element model according to the present invention, a finite element model of an analysis object, which is made up of a finite number of elements and has a plurality of node points, is produced by the use of a computer.

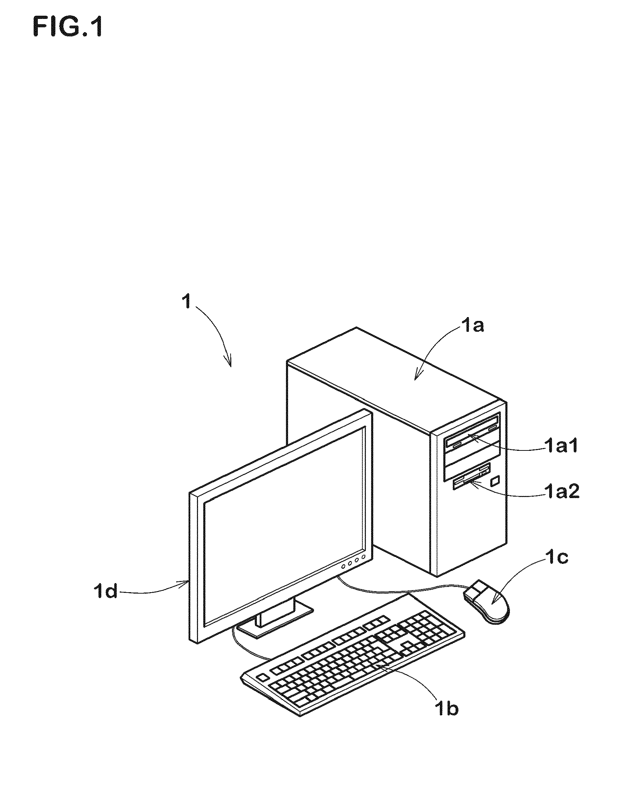

As shown in Fig. 1 for example, the computer 1 comprises a main body 1a, a keyboard 1b, a mouse 1c and a display 1d. The main body 1a comprises an arithmetic processing unit (CPU), memory, storage devices such as magnetic disk, disk drives 1a1 and 1a2 and the like. In the storage device, programs/software for carrying out the making are stored.

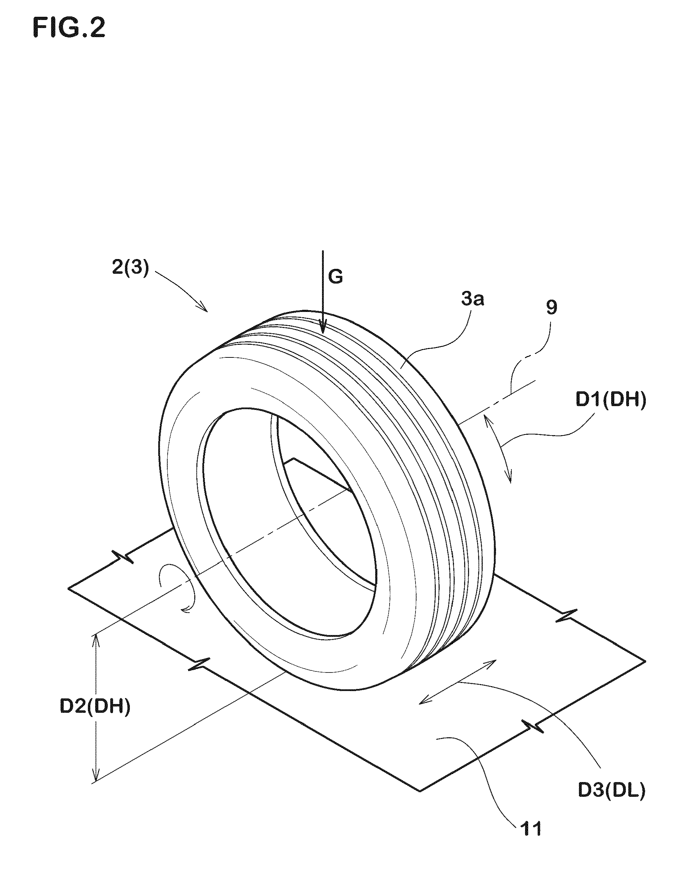

In the first embodiment, the analysis object 2 is a pneumatic tire 3 as shown in Fig. 2.

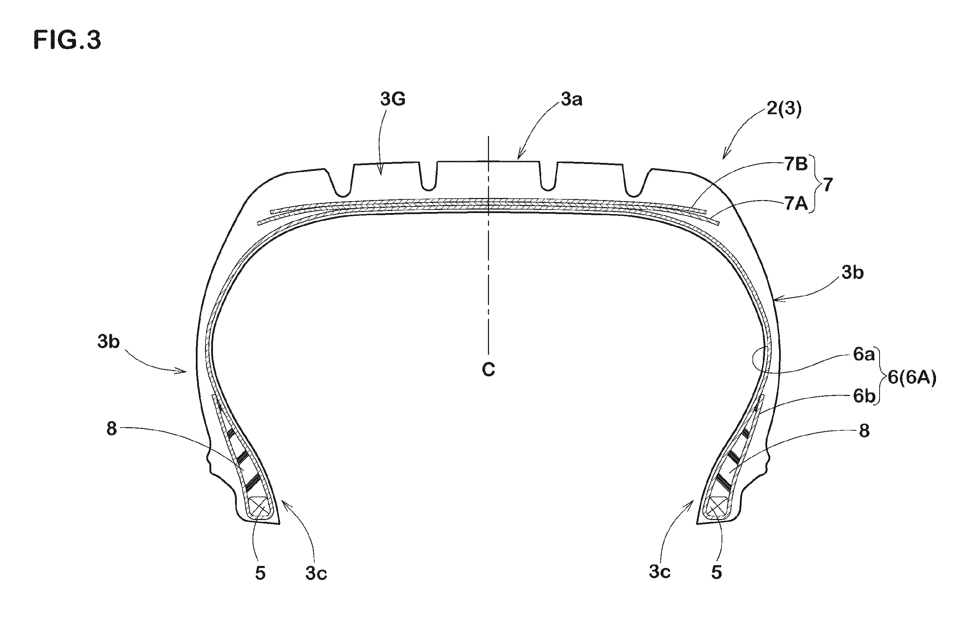

As shown in Fig. 3, the pneumatic tire 3 comprises a tread portion 3a, a pair of sidewall portions 3b, a pair of bead portions 3c each with a bead core 5 therein, a carcass 6 extending between the bead portions 3c, and a belt layer 7 disposed radially outside the carcass 6 in the tread portion 3a. The carcass 6 is composed of at least one ply 6A of cords arranged at an angle of 70 to 90 degrees with respect to the tire equator C. The carcass ply 6A extends between the bead portions 3c and is turned up around the bead cores 5 from the inside to the outside of the tire so as to have a pair of turnup portions 6b and a main portion 6a therebetween. The bead portions 3c are each provided between the main portion 6a and turnup portion 6b with a bead apex rubber 8 extending radially outwardly from the bead core 5.
The belt layer 7 comprises two cross plies 7A and 7B of parallel cords laid at an angle of 10 to 35 degrees with respect to the tire circumferential direction.

Fig. 2 shows the tire 3 rolling on a road surface 11. The tire 3 rotates around a substantially horizontal axle 9 under a vertical load G.
During rolling, the tire 3 is largely deformed and the stress gradient becomes high in the tire circumferential direction D1 and tire radial direction D2. In the tire axial direction D3, however, deformation of the tire 3 is relatively small, and the stress gradient becomes low.
Therefore, in a computer simulation of a rolling tire, each of the tire circumferential direction D1 and tire radial direction D2 is a high-precision direction DH in which the analytical accuracy has to be relatively increased. The tire axial direction D3 is a low-precision direction DL in which the analytical accuracy can be relatively decreased.

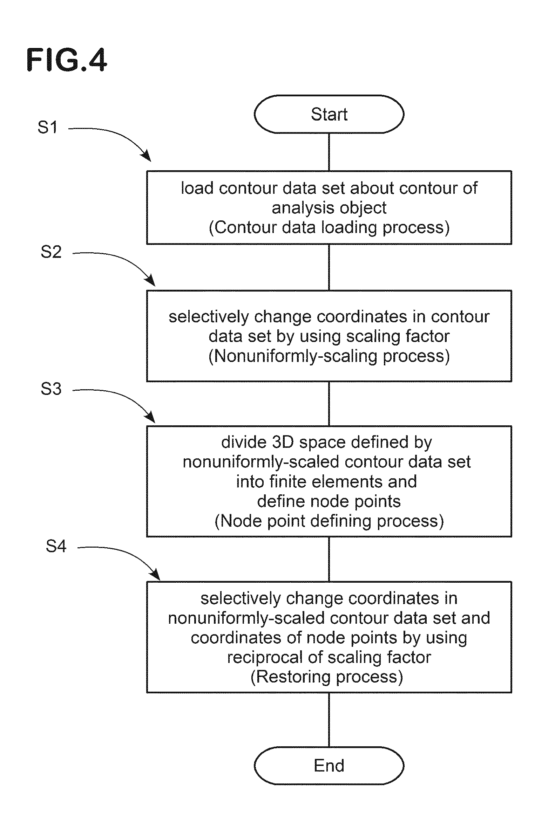

Fig. 4 shows a flowchart of a method according to the present invention.

### * Contour data loading process S1

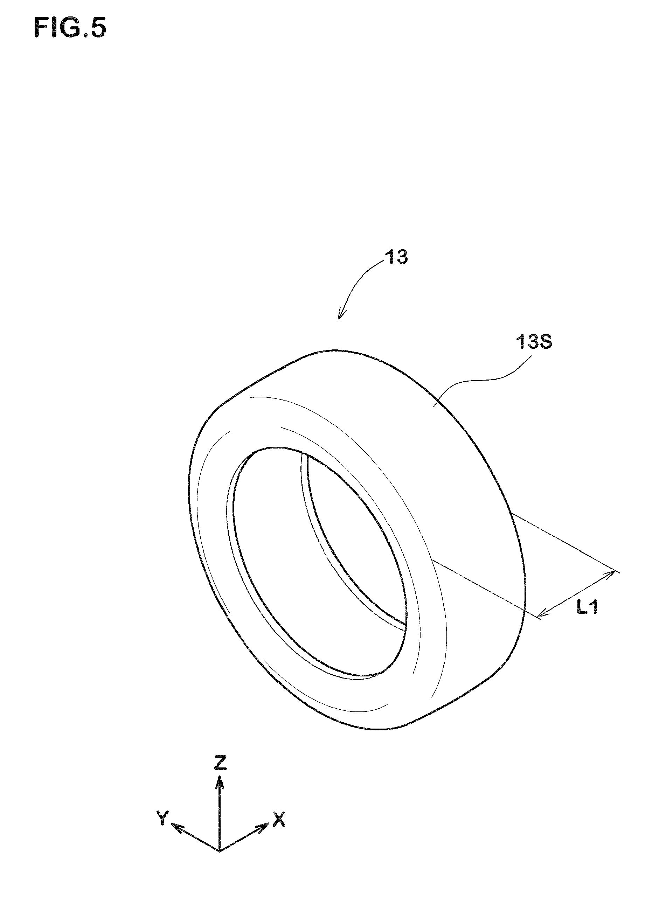

In the first process S1, the computer 1 loads a data set about the contour of the analysis object 2 as shown in Fig. 5 (hereinafter the contour data set 13).

The contour data set 13 includes coordinates which specify the contour 13S of the three-dimensional analysis object 2.
The contour 13S is a generic expression which may include the contours of the tread portion 3a, a tread rubber 3G, the carcass 6, the belt layer 7, the bead cores 5 and the like. Although, tread grooves or a tread pattern is omitted in the drawings, coordinates which specify the tread pattern may be included in the contour data set 13.

In this embodiment, the Cartesian coordinate system or X-Y-Z coordinate system is employed, therefore, the coordinates are plural sets of an X-axis coordinate value, a Y-axis coordinate value and a Z-axis coordinate value. The contour data set 13 may be obtained from the CAD data of the analysis object 2.

### * Nonuniformly-scaling process S2

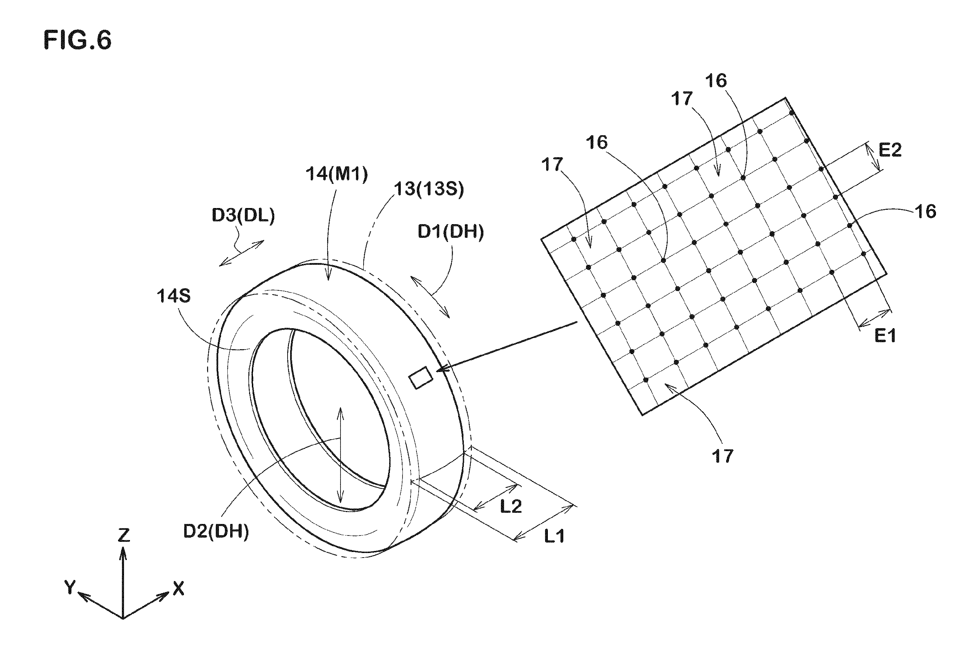

In the next process S2, as shown in Fig. 6, the computer 1 selectively changes the coordinates in the contour data set 13 by using a predetermined scaling factor R.
The scaling factor R is a reduction or enlargement rate based on the original size of the contour 13S being 1.0.

In the nonuniformly-scaling process S2 in this embodiment, only the X-axis coordinates in the contour data set 13 are changed so that
a distance L1 in the tire axial direction D3, namely, X-axis direction becomes decreased to a distance L2 which is equal to the distance L1 multiplied by the scaling factor R. It is preferable that the scaling up or down is made not to change the position of the tire equatorial plane in relation to the employed coordinate system.

Thus, in the process S2, from the contour data set 13, the computer 1 reconstructs a nonuniformly-scaled contour data set 14 which specifies the nonuniformly-scaled contour 14S obtained by anisotropically scaling the original contour 13S, for example scaling down only in the tire axial direction D3.

### * Node point defining process S3

In process S3, the computer 1 divides the 3D space defined by the nonuniformly-scaled contour data set 14 into a finite number of elements 17 and defines node points 16 on the divided elements 17.
In this embodiment, such meshing is made so that the distances E1, E2 between the node points 16 in the tire circumferential direction D1, the tire radial direction D2 and the tire axial direction D3 have substantially same values.
In this embodiment, all of the elements 17 are hexahedral solid elements. However, a tetrahedral solid element and a pentahedral solid element may be used according to need. Such meshing can be made readily by the use of a meshing software available from the market such as "ICEM CFD" a product of ANSYS, Inc.

For each of the elements 17, there are defined numerical data about an element number, node points' numbers, X, Y and Z-axis coordinate values of the node points 16, material characteristics for example, density, Young's modulus, damping factor and the like, and such numerical data are stored in the computer 1.

Thus, the computer 1 produces a primary finite element model M1 having the nonuniformly-scaled contour 14S.

### * Restoring process S4

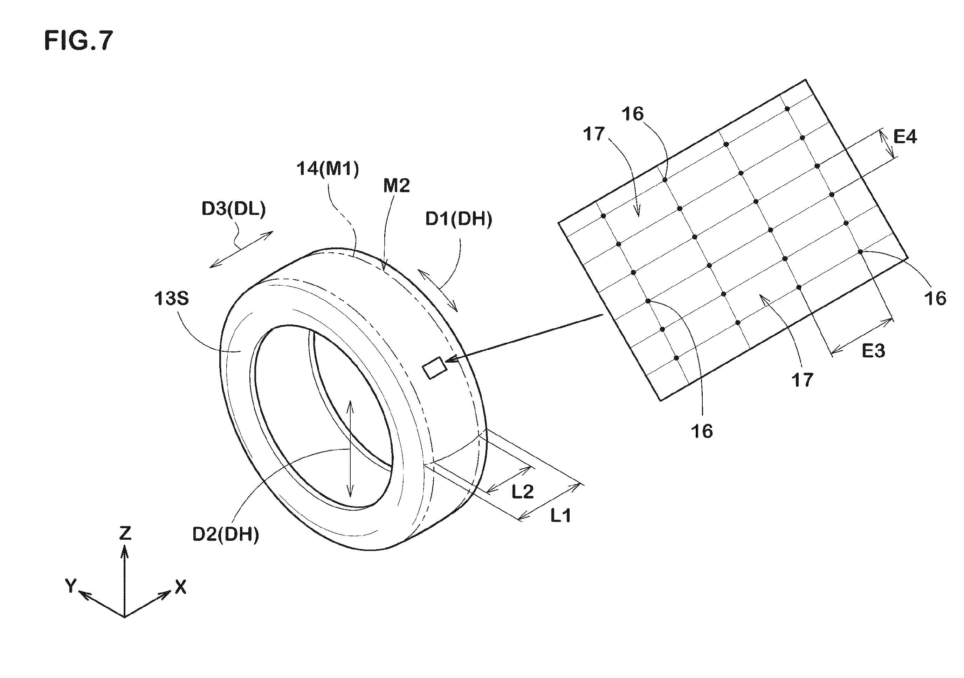

In process S4, the computer 1 selectively changes the coordinates in the nonuniformly-scaled contour data set 14 of the primary finite element model M1 and the coordinates of the node points 16 by using the reciprocal of the above-mentioned scaling factor R.
In this embodiment, as shown in Fig. 7, only the X-axis coordinates in the nonuniformly-scaled contour data set 14 are changed so that the distance L2 in the tire axial direction D3, namely, X-axis direction becomes increased to the original distance L1, by multiplying the reciprocal of the scaling factor R.

Thus, in the process S4, from the nonuniformly-scaled contour data set 14, the computer 1 produces the finite element model M2 having the original contour 13S obtained by scaling up the primary finite element model M1 only in the tire axial direction D3.
Therefore, as is clear from the comparison between Fig. 6 and Fig. 7, the distances E3 in the tire axial direction D3 between the node points 16 of the finite element model M2 are increased from the distances E1 in the tire axial direction D3 between the node points 16 of the primary finite element model M1. Accordingly, the density in the tire axial direction D3 of the node points 16 of the finite element model M2 is decreased by the scaling factor R when compared with the density in the tire axial direction D3 of the node points 16 of the primary finite element model M1.
In contrast, the distances E4 in the tire circumferential direction D1 between the node points 16 and the distance in the tire radial direction D2 between the node points 16 of the finite element model M2 are not changed when compared with the distances E2 in the tire circumferential direction D1 between the node points 16 and the distance in the tire radial direction D2 between the node points 16 of the primary finite element model M1.
Accordingly, in both of the finite element model M2 and primary finite element model M1, the density in the tire circumferential direction D1 of the node points 16 and the density in the tire radial direction D2 of the node points 16 are the same.

In this embodiment, it is desirable that the scaling factor R is not less than 1/100, preferably not less than 1/10, more preferably not less than 1/9, but less than 1, preferably not more than 2/3.
If the scaling factor R is less than 1/100, then the density in the tire axial direction D3 of the node points 16 is excessively decreased, and it becomes difficult to obtain necessary computational accuracy.

Since the tire axial direction D3 is the low-precision direction DL, in the nonuniformly-scaling process S2 of the above described embodiment, the contour 13S of the tire 3 is scaled down only in the tire axial direction D3 as shown in Fig. 6.

Conversely, each of the tire circumferential direction D1 and tire radial direction D2 are a high-precision direction DH.

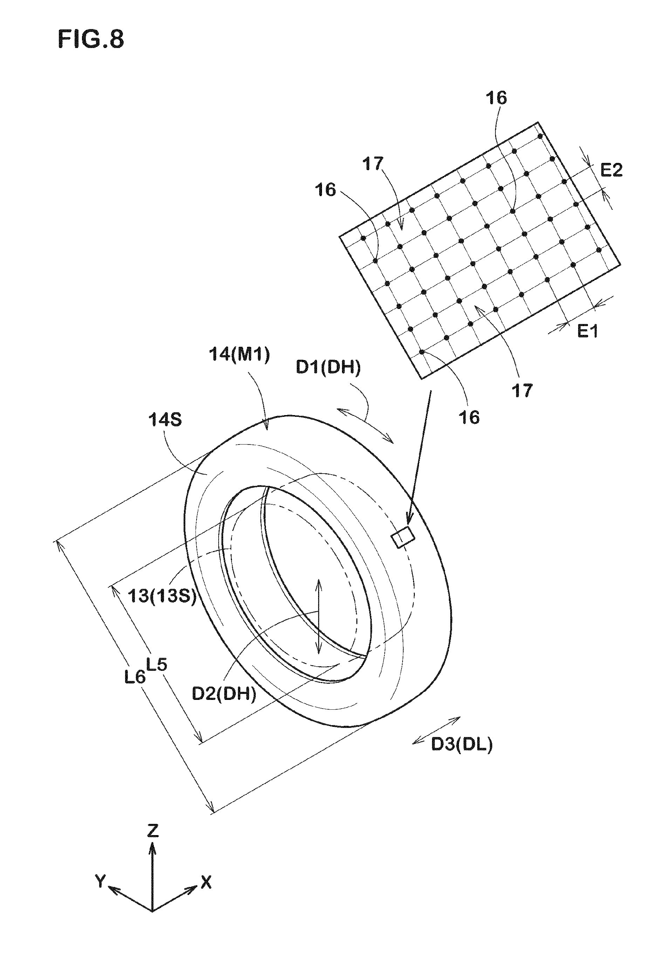

Therefore, in the nonuniformly-scaling process S2 of another embodiment of the present invention, as shown in Fig. 8, the contour 13S of the tire 3 is scaled up only in the directions D1 and D2.
In this embodiment, only the Y-axis coordinate values and Z-axis coordinate values in the contour data set 13 are changed so that the distance L5 in the tire radial direction D2 becomes increased to a distance L6 which is equal to the distance L5 multiplied by the scaling factor R, without changing the position of the tire rotation axis 9 in relation to the employed coordinate system.
In this embodiment, it is desirable that the scaling factor R is more than 1, preferably not less than 1.5, but not more than 100, preferably not more than 10, more preferably not more than 4.

Thus, from the contour data set 13, the computer 1 reconstructs a nonuniformly-scaled contour data set 14 which specifies the nonuniformly-scaled contour 14S obtained by scaling up the original contour 13S only in the tire circumferential direction D1 and tire radial direction D2, by multiplying the scaling factor R.

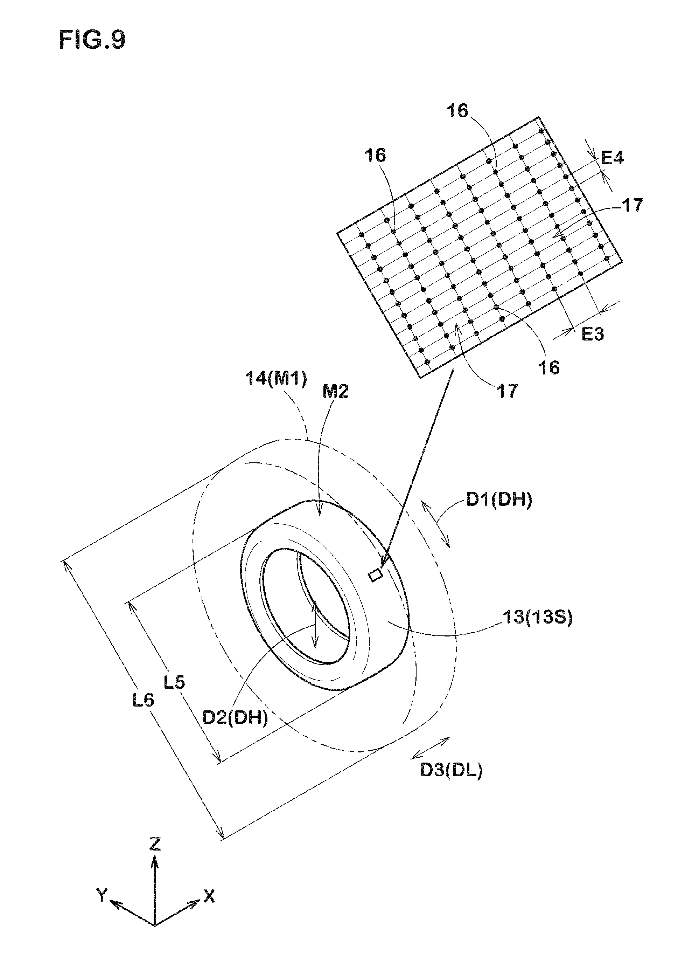

In the restoring process S4, only the Y-axis coordinate values and Z-axis coordinate values in the nonuniformly-scaled contour data set 14 are changed so that, as shown in Fig. 9, the distance L6 in the tire radial direction D2 becomes decreased to the original distance L5, by multiplying the reciprocal of the scaling factor R.

Thus, the primary finite element model M1 is scaled down only in the tire circumferential direction D1 and tire radial direction D2, and thereby, the finite element model M2 having the original contour 13S is produced by the computer 1.

In this embodiment, the distances E4 in the tire circumferential direction D1 between the node points 16 of the finite element model M2 and the distances in the tire radial direction D2 between the node points 16 of the finite element model M2 become decreased by the reciprocal of the scaling factor R when compared with the distances E2 in the tire circumferential direction D1 between the node points 16 of the primary finite element model M1 and the distances in the tire radial direction D2 between the node points 16 of the primary finite element model M1.
Accordingly, the density of the node points 16 of the finite element model M2 in the tire circumferential direction D1 and the tire radial direction D2 is increased by the scaling factor R when compared with the density in the primary finite element model M1.
The distances E3 in the tire axial direction D3 between the node points 16 of the finite element model M2 and the distances E1 in the tire axial direction D3 between the node points 16 of the primary finite element model M1 are the same.
Accordingly, the density in the tire axial direction D3 of the node points 16 of the finite element model M2 is the same as the density in the tire axial direction D3 of the node points 16 of the primary finite element model M1.

In the nonuniformly-scaling process S2 of a further embodiment of the present invention, the contour 13S of the tire 3 is scaled down in the tire axial direction D3 by using a first scaling factor R less than 1 and scaled up in the tire circumferential direction D1 and tire radial direction D2 by using a second scaling factor R more than 1.
In the restoring process S4, the nonuniformly-scaled contour 14S is scaled up in the tire axial direction D3 by using the reciprocal of the first scaling factor R and scaled down in the tire circumferential direction D1 and tire radial direction D2 by using the reciprocal of the second scaling factor R.

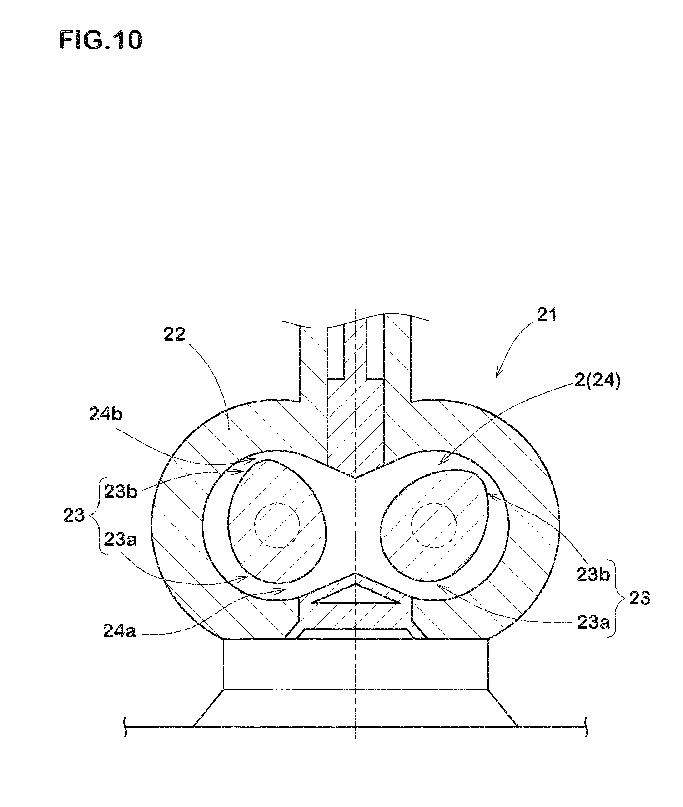

Figs.10-13 show a further embodiment of the present invention.

In this embodiment, the analysis object 2 is a kneading space 24 of a kneading machine 21. The kneading space 24 is defined by the inner surface of the casing 22 and the outer surface of a pair of rotors 23 disposed in the casing 22. The rotor 23 is provided with a blade 23b protruding from the cylindrical main portion 23a. As shown in Fig. 10, the cross sectional shape of the kneading space 24 is a figure of eight. The kneading space 24 includes a wide space 24a between the main portion 23a of the rotor 23 and the casing 22 and a narrow space 24b between the blade 23b and the casing 22.

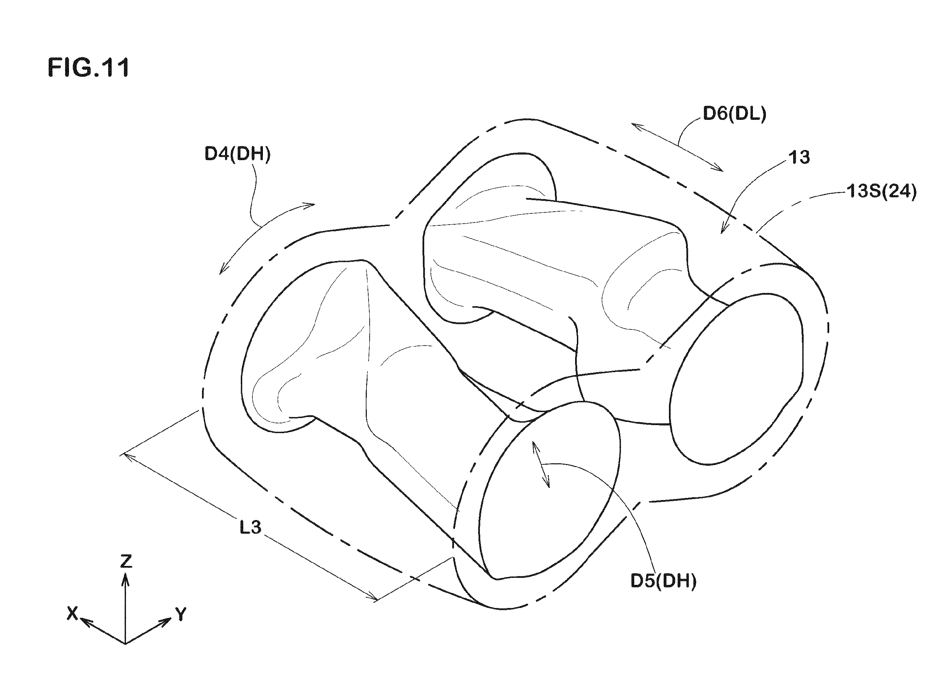

A fluid material put in the kneading space 24 receives a larger stress when passing through the narrow space 24b as a consequence of the rotation of the rotor 23.
Therefore, the stress gradient of the fluid material becomes high in the circumferential direction D4 of the rotor and the radial direction D5 of the rotor as shown in Fig. 11. On the other hand, the stress gradient becomes relatively low in the axial direction D6 of the rotor.
Thus, in a kneading simulation using the computer 1, each of the circumferential direction D4 of the rotor and the radial direction D5 of the rotor is a high-precision direction DH in which analytical accuracy has to be relatively increased. The axial direction D6 of the rotor is a low-precision direction DL in which the analytical accuracy can be relatively decreased.

In this embodiment too, the producing method is performed according to the flowchart shown in Fig. 4.

In the contour data loading process S1, the computer 1 loads a contour data set 13 which specifies the contour 13S of the kneading space 24 as shown in Fig. 11. In this embodiment too, the Cartesian coordinate system is employed,

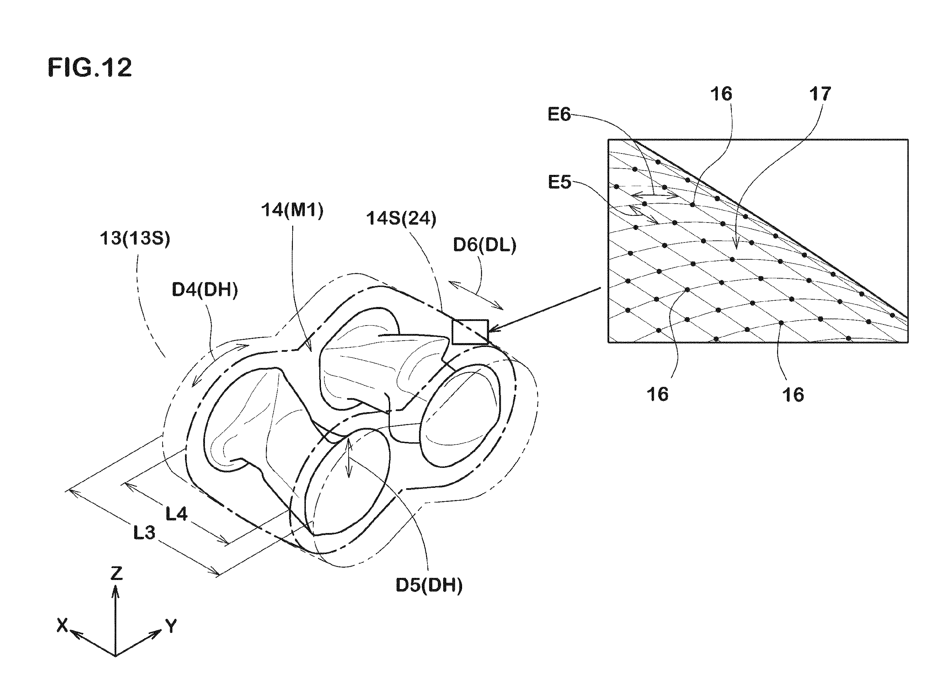

In the nonuniformly-scaling process S2, only the X-axis coordinate values in the contour data set 13 are changed so that, as shown in Fig. 12, a distance L3 in the axial direction D6 of the rotor (X-axis direction) becomes decreased to a distance L4 which is equal to the distance L3 multiplied by a scaling factor R less than 1.

Thus, from the contour data set 13, the computer 1 reconstructs a nonuniformly-scaled contour data set 14 which specifies a nonuniformly-scaled contour 14S obtained by scaling down the contour 13S only in the axial direction D6 of the rotor, by multiplying the scaling factor R.

In the node point defining process S3, the computer 1 divides the nonuniformly-scaled contour 14S into a finite number of elements 17 and defines node points 16 on the divided elements 17.
Thus, a primary finite element model M1 having the nonuniformly-scaled contour 14S is produced.

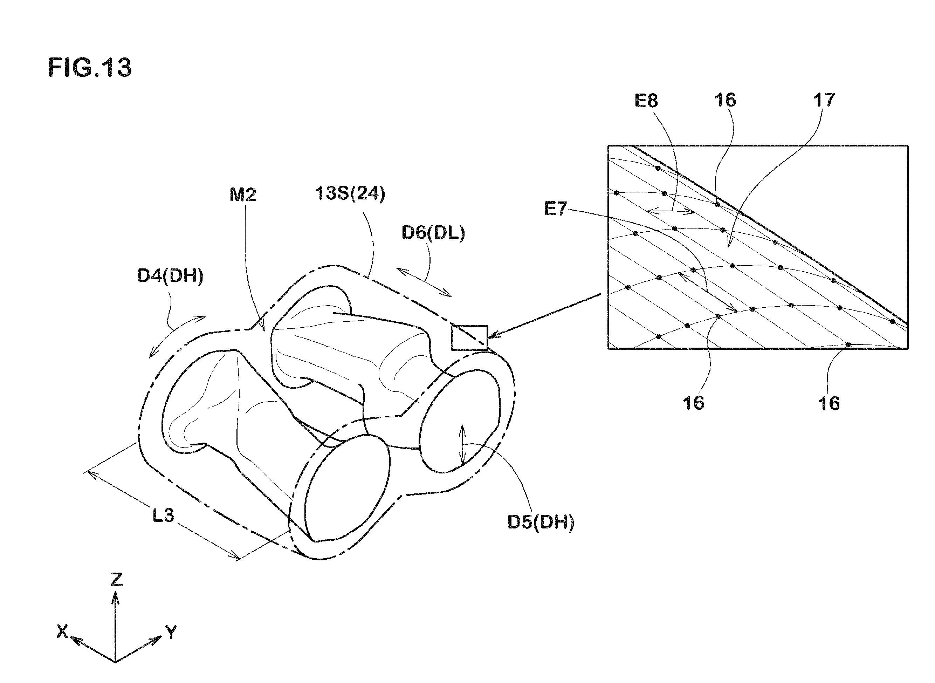

In the restoring process S4, only the X-axis coordinate values in the nonuniformly-scaled contour data set 14 are changed so that, as shown in Fig. 13, the distance L4 in the axial direction D6 of the rotor becomes increased to the original distance L3, by multiplying the reciprocal of the scaling factor R.
Thereby, the finite element model M2 having the original contour 13S is produced by the computer 1.

The distances E7 in the axial direction D6 of the rotor between the node points 16 of the finite element model M2 are increased by the reciprocal of the scaling factor R when compared with the distances E5 in the primary finite element model M1.
Accordingly, the density in the axial direction D6 of the rotor of the node points 16 of the finite element model M2 is decreased by the scaling factor R when compared with the density in the primary finite element model M1.

The distances E8 in the circumferential direction D4 of the rotor between the node points 16 of the finite element model M2, the distances in the radial direction D5 of the rotor between the node points 16 of the finite element model M2, are not changed when compared with the distances E6 in the circumferential direction D4 of the rotor between the node points 16 of the primary finite element model M1, and the distances in the radial direction D5 of the rotor between the node points 16 of the primary finite element model M1. Accordingly, the density in the circumferential direction D4 of the rotor of the node points 16 of the finite element model M2, and the density in the radial direction D5 of the rotor of the node points 16 of the finite element model M2, are the same as the density in the circumferential direction D4 of the rotor of the node points 16 of the primary finite element model M1, and the density in the radial direction D5 of the rotor of the node points 16 of the primary finite element model M1. It is desirable that the scaling factor R is not less than 1/100 and not more than 1/2.

In the nonuniformly-scaling process S2 of another embodiment of present invention, the contour 13S is scaled up only in the circumferential direction D4 of the rotor and the radial direction D5 of the rotor.
Then, in the restoring process S4, the nonuniformly-scaled contour 14S is scaled down only in the circumferential direction D4 of the rotor and the radial direction D5 of the rotor.

In the nonuniformly-scaling process S2 of a further embodiment of present invention, the contour 13S is scaled down in the axial direction D6 of the rotor and scaled up in the circumferential direction D4 of the rotor and the radial direction D5 of the rotor.
Then, in the restoring process S4, the nonuniformly-scaled contour 14S is scaled up in the axial direction D6 of the rotor and scaled down in the circumferential direction D4 of the rotor and the radial direction D5 of the rotor.

In the above embodiments, the Cartesian coordinate system is employed. But, a cylindrical coordinate system, spherical coordinate system, and toroidal coordinate system may be employed.

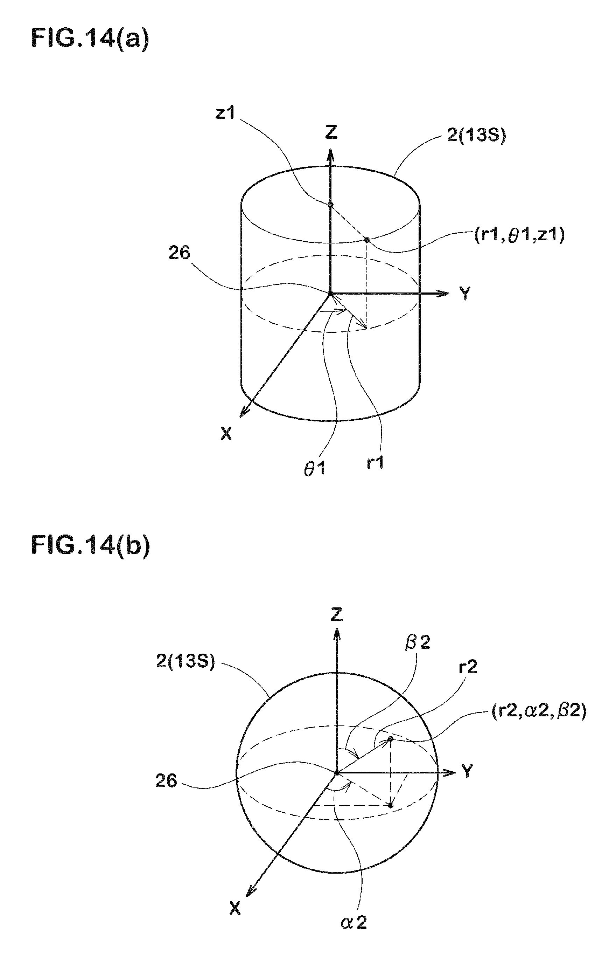

Fig. 14 (a) shows a cylindrical coordinate system, wherein a point is defined by three coordinates (r1, θ1, z1) (r1 is the radial distance, θ1 is the azimuth, and z1 is the height).

Fig. 14 (b) shows a spherical coordinate system, wherein a point is defined by three coordinates (r2, β2, α2) (r2 is the radial distance, β2 is the polar angle, and α2 is the azimuthal angle).

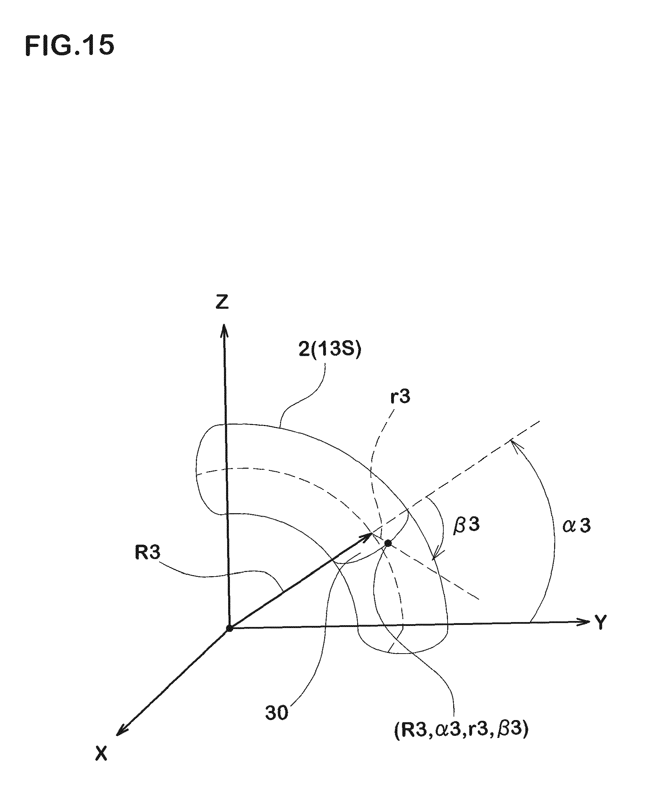

Fig. 15 shows a toroidal coordinate system, wherein a point is defined by four coordinates (R3, α3, r3, β3) (R3 is the major radius, α3 is the toroidal angle, r3 is the minor radius, and β3 is the poloidal angle).

### Comparison Tests

Finite element models (embodiments 1 to 6) of a pneumatic tire (size 285/60 R18) shown in Fig. 2 were produced according to the procedure shown in Fig. 4.
Embodiment 1: In the nonuniformly-scaling process, the contour shape of the tire was scaled down only in the tire axial direction by a scaling factor of 1/2. Thus, the density of the node points in the tire axial direction was decreased to one-half of the density in the tire circumferential direction and tire radial direction.
Embodiment 2: Similarly, the density of the node points in the tire axial direction was decreased to one third.
Embodiment 3: Similarly, the density of the node points in the tire axial direction was decreased to one tenth.
Embodiment 4: Similarly, the density of the node points in the tire axial direction was decreased to thousandth part.
Embodiment 5: In the nonuniformly-scaling process, the contour shape of the tire was scaled up only in the tire circumferential direction and the tire radial direction by a scaling factor of 3. Thus, the density in the tire circumferential direction and tire radial node points was increased to three times the density in the tire axial direction.
Embodiment 6: In the finite element model M2, the density of the node points in the tire axial direction was decreased to 1/3 of the density of the node points in the tire axial direction in the primary finite element model, and further the density of the node points in the tire circumferential direction and the tire radial direction was increased to three times the density of the node points in the tire circumferential direction and the tire radial direction in the primary finite element model.

For comparison, finite element models (comparative example 1, comparative example 2) of the pneumatic tire were produced manually.
comparative example 1: The density of the node points in the tire axial direction, the tire circumferential direction and the tire radial direction was substantially constant.
comparative example 2: The density of the node points was same as that of Embodiment 1.
   Further, a finite element model (comparative example 3) of the pneumatic tire was produced by a computer using a mesh 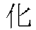 software.
comparative example 3: The density of the node points in the tire axial direction, the tire circumferential direction and the tire radial direction was substantially constant.

### < Simulation accuracy >

Using a general-purpose finite element program software "LS-DYNA" a product of LSTC, the ground contacting area of the tire under a tire load of 630 kgf and a tire pressure of 230 kPa was calculated and compared with the measured ground contacting area. The results are shown in Table 1 by an index based on the measured ground contacting area being 100. If the index is within a range from 90 to 110, the simulation result is considered as being accurate.

### < model producing time and simulation time >

The model producing time, namely, the time to produce the finite element model and the simulation time, namely, the time to calculate the ground contacting area were measured. The results are shown in Table 1.

**Table 1**

| | comparative example 1 | comparative example 2 | comparative example 3 | embodiment 1 | embodiment 2 | embodiment 3 | embodiment 4 | embodiment 5 | embodiment 6 |
|---|---|---|---|---|---|---|---|---|---|
| shape of elements | hexahedron | hexahedron | tetrahedron | tetrahedron | tetrahedron | tetrahedron | tetrahedron | tetrahedron | tetrahedron |
| number of elements | 255150 | 180350 | 1000302 | 610350 | 400230 | 112050 | 13500 | 3511503 | 1201530 |
| axial node point density (*1) | 1 | 1/3 | 1 | 1/2 | 1/3 | 1/10 | 1/100 | 1 | 1/3 |
| circumferential node point density (*1) | 1 | 1 | 1 | 1 | 1 | 1 | 1 | 3 | 3 |
| radial node point density (*1) | 1 | 1 | 1 | 1 | 1 | 1 | 1 | 3 | 3 |
| simulation accuracy | 102 | 102 | 104 | 103 | 105 | 90 | 75 | 102 | 108 |
| model producing time (hour) | 45.0 | 64.0 | 2.0 | 2.5 | 2.5 | 3.0 | 3.0 | 5.5 | 5.0 |
| simulation time (hour) | 82.0 | 53.0 | 260.0 | 153.0 | 110.0 | 50.0 | 10.0 | 685.0 | 380.5 |
| total time (hour) | 127.0 | 117.0 | 262.0 | 155.5 | 112.5 | 53.0 | 13.0 | 690.5 | 385.5 |

| | | | | | | | | | |
|---|---|---|---|---|---|---|---|---|---|
| *1) ratio based on the density in the primary finite element model of embodiment 1 being 1.0 | | | | | | | | | |

when compared with the finite element model as comparative example 3, the finite element models as embodiments 1 to 4 could remarkably decrease the simulation time.

when compared with the finite element models as comparative examples 1 to 3 and embodiments 1 to 4, the finite element models as embodiments 5 to 6 could increase the simulation accuracy.

As described above, in the method for producing a finite element model according to the present invention, the density in the low-precision direction of the node points of the finite element model is relatively decreased, in other words, the density in the high-precision direction of the node points of the finite element model is relatively increased.

when compared with a finite element model whose node point density is increased equally in every direction, the finite element model produced according to the present invention can reduce physical quantity to be calculated at the node points. Therefore, by employing such finite element model in a computer simulation, both of the computational efficiency and the analytical accuracy can be achieved.

## Claims

1. A method for producing a finite element model of an analysis object, comprising:
a process in which a computer loads a contour data set which is a data set including coordinates which specify the contour of the analysis object,
a nonuniformly-scaling process in which the computer selectively changes the coordinates in the contour data set by using a predetermined scaling factor so as to obtain a nonuniformly-scaled contour data set which specify a nonuniformly-scaled contour obtained by anisotropically scaling up or scaling down the contour of the analysis object according to the scaling factor,
a primary model producing process in which the computer divides the three-dimensional space defined by the nonuniformly-scaled contour data set into a finite number of elements and defines node points on the divided elements so as to form a primary finite element model having the nonuniformly-scaled contour,
a restoring process in which the computer selectively changes the coordinates in the nonuniformly-scaled contour data set and the coordinates of the node points of the primary finite element model by using the reciprocal of the scaling factor so as to obtain the finite element model having the contour of the analysis object obtained by anisotropically scaling down or scaling up the primary finite element model according to the reciprocal of the scaling factor.

2. The method according to claim 1, wherein
the analysis object has a low-precision direction in which analytical accuracy can be relatively decreased, and
in the nonuniformly-scaling process, the contour of the analysis object is scaled down only in the low-precision direction, and
in the restoring process, the primary finite element model is scaled up only in the low-precision direction.

3. The method according to claim 1, wherein
the analysis object has a high-precision direction in which analytical accuracy has to be relatively increased, and
in the nonuniformly-scaling process, the contour of the analysis object is scaled up only in the high-precision direction, and
in the restoring process, the primary finite element model is scaled down only in the high-precision direction.

4. The method according to claim 3, wherein
the analysis object has two high-precision directions.

5. The method according to claim 2, wherein
the analysis object is a vehicle tire, and
the low-precision direction is the axial direction of the tire.

6. The method according to claim 4, wherein
the analysis object is a vehicle tire, and
the high-precision directions are the radial direction and the circumferential direction of the tire.

7. The method according to claim 2, wherein
the analysis object is a kneading space of a kneading machine in which a rotor is disposed, and
the low-precision direction is the axial direction of the rotor.

8. The method according to claim 4, wherein
the analysis object is a kneading space of a kneading machine in which a rotor is disposed, and
the high-precision directions are the circumferential direction of the rotor and the axial direction of the rotor.

9. The method according to any of claims 1 to 8, wherein
the employed coordinate system is one selected from the Cartesian coordinate system, a cylindrical coordinate system, a spherical coordinate system and a toroidal coordinate system.
